# EUROPEAN PATENT APPLICATION

(11) **EP 3 007 239 A1**
(43) Date of publication of application: **13.04.2016**
(21) Application number: 15170059.8
(22) Date of filing: 01.06.2015
(51) Int. Cl.: H01L 33/44, H01L 33/50

(54) **SEMICONDUCTOR LIGHT EMITTING DEVICE AND METHOD FOR MANUFACTURING THE SAME**

(30) Priority: 08.10.2014 JP 2014207036; 07.04.2015 JP 2015078346
(71) Applicant: Kabushiki Kaisha Toshiba, Tokyo (JP)
(72) Inventor: Furuyama, Hideto, Tokyo (JP)
(74) Representative: Hoffmann Eitle

(57) **Abstract**

According to one embodiment, a semiconductor light emitting device includes a light emitting element (15), a fluorescent material layer (30), and an inorganic material layer (19). The light emitting element has an asperity surface (15a). The fluorescent material layer is provided on the asperity surface. The fluorescent material layer has a glass member and a fluorescent material dispersed in the glass member. The inorganic material layer is provided between the asperity surface and the fluorescent material layer. The inorganic material layer is in contact with the asperity surface and the fluorescent material layer, and transmissive to light emitted from the light emitting element.

## Description

### FIELD

Embodiments described herein relate generally to a semiconductor light emitting device and a method for manufacturing the same.

### BACKGROUND

Recently, semiconductor light emitting devices having a white light source by combining a nitride semiconductor and a fluorescent material have been widely used. Particularly, in the high-power semiconductor light emitting devices, countermeasures against heat not only in the light emitting element but also in the fluorescent material layer is highly demanded.

### BRIEF DESCRIPTION OF THE DRAWINGS

FIGS. 1A to 2C are schematic enlarged sectional views of a part of a semiconductor light emitting device of an embodiment;
FIGS. 3A to 4B are schematic sectional views showing a method for manufacturing the semiconductor light emitting device of the embodiment;
FIG. 5 is a schematic sectional view of the semiconductor light emitting device of the embodiment;
FIGS. 6A and 6B are schematic plan views of the semiconductor light emitting device of the embodiment;
FIG. 7 is a schematic sectional view of the semiconductor light emitting device of the embodiment;
FIG. 8 is a schematic plan view of the semiconductor light emitting device of the embodiment;
FIG. 9 is a schematic sectional view of a semiconductor layer of the embodiment;
FIG. 10 is a schematic sectional view of the semiconductor light emitting device of the embodiment;
FIGS. 11A to 11C are schematic enlarged sectional views of a part of the semiconductor light emitting device of the embodiment; and
FIGS. 12A and 12B are wavelength dependence chart of a reflectance of a fluorescent reflection film of the embodiment.

### DETAILED DESCRIPTION

According to one embodiment, a semiconductor light emitting device includes a light emitting element, a fluorescent material layer, and an inorganic material layer. The light emitting element has an asperity surface. The fluorescent material layer is provided on the asperity surface. The fluorescent material layer has a glass member and a fluorescent material dispersed in the glass member. The inorganic material layer is provided between the asperity surface and the fluorescent material layer. The inorganic material layer is in contact with the asperity surface and the fluorescent material layer, and transmissive to light emitted from the light emitting element.

Hereinafter, embodiments will be described with reference to the drawings. In the drawings, the same elements will be denoted by the same reference signs.

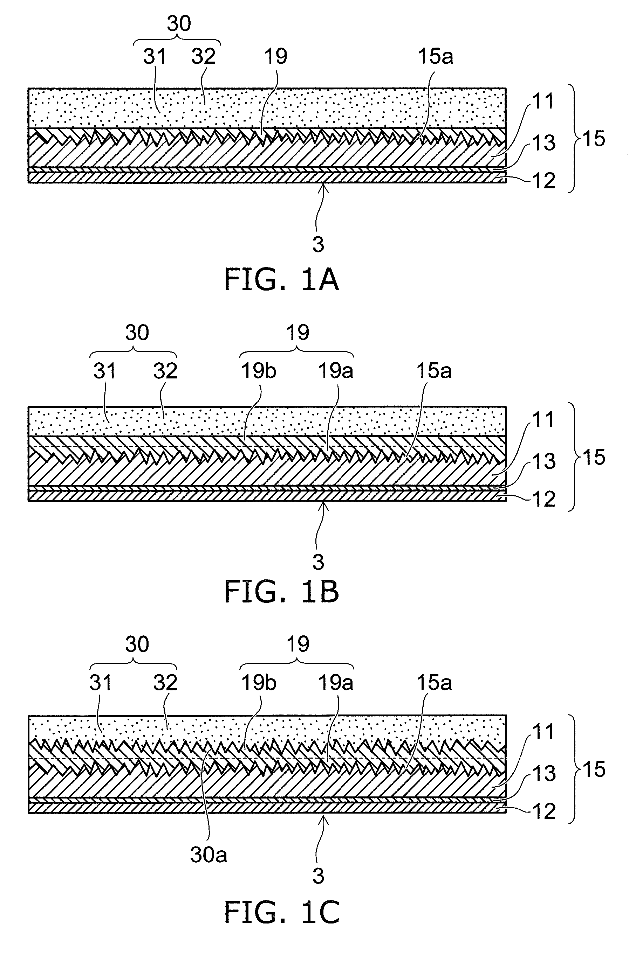

FIG. 1A is a schematic enlarged sectional view of a part of a semiconductor light emitting device of an embodiment.

The semiconductor light emitting device of the embodiment has a light emitting element 3, a fluorescent material layer 30, and a transparent inorganic material layer 19 provided between the light emitting element 3 and the fluorescent material layer 30.

The light emitting element 3 has a semiconductor layer 15 including a nitride semiconductor. In this specification, the "nitride semiconductor" includes a III-V group compound semiconductor expressed by the chemical formula: BₓIn_{y}Al_{z}Ga_{1-x-y-z}N (where 0≤x≤1, 0≤y≤1, 0≤z≤1, 0≤x+y+z≤1) and may be a mixed crystal containing phosphorus (p), arsenic (As) and the like as a V group element in addition to nitride (N). The "nitride semiconductor" also includes materials further containing various elements added to control various properties such as a conductive property, and materials further containing various elements included unintentionally.

The semiconductor layer 15 has a first layer 11 including an n-type cladding layer, a second layer 12 including a p-type cladding layer, and a light emitting layer (active layer) 13 provided between the first layer 11 and the second layer 12.

The n-type cladding layer is, for example, an n-type GaN layer, and supplies electrons to the light emitting layer 13 with the forward bias to the p-n junction. The p-type cladding layer is, for example, a p-type GaN layer, and supplies holes to the light emitting layer 13 with the forward bias to the p-n junction.

The light emitting layer 13 has, for example, a multiple quantum well (MQW) structure having a plurality of well layers and a plurality of barrier layers laminated alternately.

The well layers have narrower band gap energy than the n-type cladding layer and the p-type cladding layer. The well layer is interposed between the barrier layers in a stacking direction and the barrier layers have wider band gap energy than the well layers. The well layers contain, for example, InGaN. The barrier layers contain, for example, GaN, and do not substantially contain In. When the barrier layers contain In, the composition ratio of In in the barrier layer is lower than a composition ratio of In in the well layer. The peak wavelength of the light emitted from the light emitting layer 13 is in the range of, for example, 360 nm to 650 nm.

The first layer 11 has an asperity surface (rough surface) 15a opposite to an interface between the first layer 11 and the light emitting layer 13. A transparent inorganic material layer 19 is provided on the asperity surface 15a. A fluorescent material layer 30 is provided on the transparent inorganic material layer 19.

The semiconductor layer 15 is epitaxially grown on a single crystalline substrate such as a gallium nitride substrate, a silicon substrate, a sapphire substrate, a silicon carbide substrate, or a gallium oxide (hereinafter, simply referred to as the substrate). The first layer 11, the light emitting layer 13, and the second layer 12 are formed in order on the substrate. Here, when the substrate (single crystalline substrate) for growing the semiconductor layer 15 is an opaque substrate such as a silicon, the substrate used for the formation (growth) of the semiconductor layer 15 is removed from the semiconductor layer 15.

Fine asperity is formed on a surface of the first layer 11 exposed due to the removal of the substrate, and thus the asperity surface 15a is formed on the light extraction side of the semiconductor layer 15. For example, the asperity surface 15a is formed by wet etching using an alkaline solution. By virtue of this asperity surface 15a, reflection components returning to the inside of the semiconductor layer 15 can be reduced and the efficiency of light extraction from the semiconductor layer 15 to the inorganic transparent layer 19 can be improved.

The transparent inorganic material layer 19 covers the asperity surface 15a, and a surface of the transparent inorganic material layer 19 opposite to the asperity surface 15a is a flat surface. That is, the interface formed between the transparent inorganic material layer 19 and the fluorescent material layer 30 is flat. The surface of the transparent inorganic material layer 19 on the side of the fluorescent material layer 30 has smaller surface roughness than the surface of the transparent inorganic material layer 19 on the side of the first layer 15.

The fluorescent material layer 30 includes a plurality of particulate fluorescent materials 31. The fluorescent materials 31 are excited by the light (excitation light) emitted from the light emitting layer 13, and emit light having a wavelength different from the wavelength of the excitation light. Pseudo white light, bulb color light or the like is obtained as mixed light of the light of the light emitting layer 13 and the light of the fluorescent materials 31.

The plurality of fluorescent materials 31 are dispersed in a glass member 32. The glass member 32 includes, for example, at least any of a borosilicate glass, a soda lime glass, an alumina silicate glass, a quartz, and quart.

In the embodiment, the glass member 32 is, for example, a sintered body including a borosilicate glass powder as a main component, and the fluorescent materials 31 are dispersed in the sintered body. The glass member 32 is transmissive to the light emitted from the light emitting layer 13 and the light emitted from the fluorescent materials 31.

The transparent inorganic material layer 19 is transmissive to the light emitted from the light emitting layer 13. In this specification, the "transmission" is not limited to a transmittance of 100% and also includes a case in which light is partially absorbed.

The transparent inorganic material layer 19 is an inorganic material layer which does not include a so-called organic compound such as a high-molecular resin and a low-molecular resin, and has, for example, resistance to heat of 300°C or higher.

The transparent inorganic material layer 19 may be a carbon compound (silicon carbide, diamond and the like) as an inorganic material, or an inorganic material containing carbon incorporated during the manufacturing. When the transparent inorganic material layer 19 is an inorganic material containing carbon incorporated therein other than a carbon compound, the weight ratio of the carbon in the transparent inorganic material layer 19 is lower than 1%.

For example, silicon oxide, silicon carbide, silicon nitride, aluminum nitride, zirconium oxide, zinc oxide, gallium oxide, aluminum oxide, diamond, silicon oxide nitride, and the like can be used for the transparent inorganic material layer 19.

Here, when the substrate (single crystalline substrate) for growing the semiconductor layer 15 is a transparent substrate such as gallium nitride, sapphire, silicon carbide, or gallium oxide, asperities may be formed on the surface of the substrate to perform crystal growth, and the transparent substrate may be subjected to, for example, thinning of 50 µm or less and surface flattening. Such transparent substrate may be used as the transparent inorganic material layer 19.

As will be described later, the fluorescent material layer 30 and the light emitting element 3 are bonded together via the transparent inorganic material layer 19, and then divided by dicing or the like. Therefore, the fluorescent material layer 30 is not provided around the light emitting element 3, and a side surface of the fluorescent material layer 30 and a side surface of the transparent inorganic material layer 19 are aligned.

A deposition film may be used as the transparent inorganic material layer 19. For example, by selecting deposition conditions of the deposition film, a dense film can be easily formed along the asperity surface 15a and the transparent inorganic material layer 19 brought into close contact with the asperity surface 15a can be formed.

A material having a Young's modulus of 300 GPa or higher may be used as the transparent inorganic material layer 19. In this case, when the semiconductor light emitting device is mounted on a mounting substrate, the stress applied to the fluorescent material layer 30 can be dispersed to the transparent inorganic material layer 19 and can thus be reduced. Accordingly, the transparent inorganic material layer 19 is preferably formed of a material having a Young's modulus of 300 GPa or higher because a deterioration in optical characteristics such as color breakup can be suppressed.

A material having a Young's modulus less than 300 GPa may be used as the transparent inorganic material layer 19. The transparent inorganic material layer 19 is preferably formed of a material having a Young's modulus less than 300 GPa because it has a structure in which the stress applied to the semiconductor layer 15 is easily relaxed by the transparent inorganic material layer 19. The Young's modulus of the transparent inorganic material layer 19 is not restricted to be less than 300 GPa. A transparent inorganic material layer 19 having a Young's modulus of 280 GPa or lower, and preferably 100 GPa or lower can be used.

The fluorescent material 31 emits light and generates heat corresponding to a wavelength conversion loss (Stokes loss).

At that time, in a structure in which the fluorescent material 31 is dispersed in a resin, the resin may deteriorate or may be decomposed due to the heat of the fluorescent materials 31. Particularly, the heat resistance of the resin may raise a problem in high-power light emitting elements.

However, according to an embodiment, since the fluorescent materials 31 are dispersed in the glass material 32 having higher heat resistance than a resin, the reliability of the fluorescent material layer 30 can be increased. The fluorescent material layer 30 does not include a resin as a binder which binds the plurality of fluorescent materials 31.

The refractive index (average refractive index) of the glass member 32 is preferably lower than the refractive index (average refractive index) of the semiconductor layer 15 and is higher than the refractive index (average refractive index) of the transparent inorganic material layer 19.

For example, the refractive index of GaN which forms the asperity surface 15a is 2.4 to 2.7, the refractive index of the glass member 32 is 1.8 or higher, and the refractive index of the transparent inorganic material layer 19 is 1.5 to 1.8.

Since the transparent inorganic material layer 19 has a lower refractive index than the glass member 32, the light is more easily taken in from the transparent inorganic material layer 19 to the glass member 32 than in a case in which the transparent inorganic material layer 19 has a higher refractive index than the glass member 32. In this case, the light (for example, blue light) of the light emitting layer 13 is confined and guided in the transparent inorganic material layer 19, and thus spreads in a transverse direction, whereby color breakup caused by the light which is emitted to the outside without exciting the fluorescent materials 31 can be suppressed and the controllability of chromaticity is high.

For example, a conductive transparent material such as indium tin oxide (ITO) can be used as the transparent inorganic material layer 19.

The transparent inorganic material layer 19 is provided to be spread on the asperity surface 15a in contact with the asperity surface 15a of the first layer 11. Therefore, when the transparent inorganic material layer 19 has a conductive property, an electric current is diffused and flows in the transverse direction in the transparent inorganic material layer 19. The electric current is easy to uniformly diffuse in the transverse direction, compared to a case in which the electric current is diffused only through the first layer 11. As a result, the in-plane light-emission intensity distribution is easily uniformed.

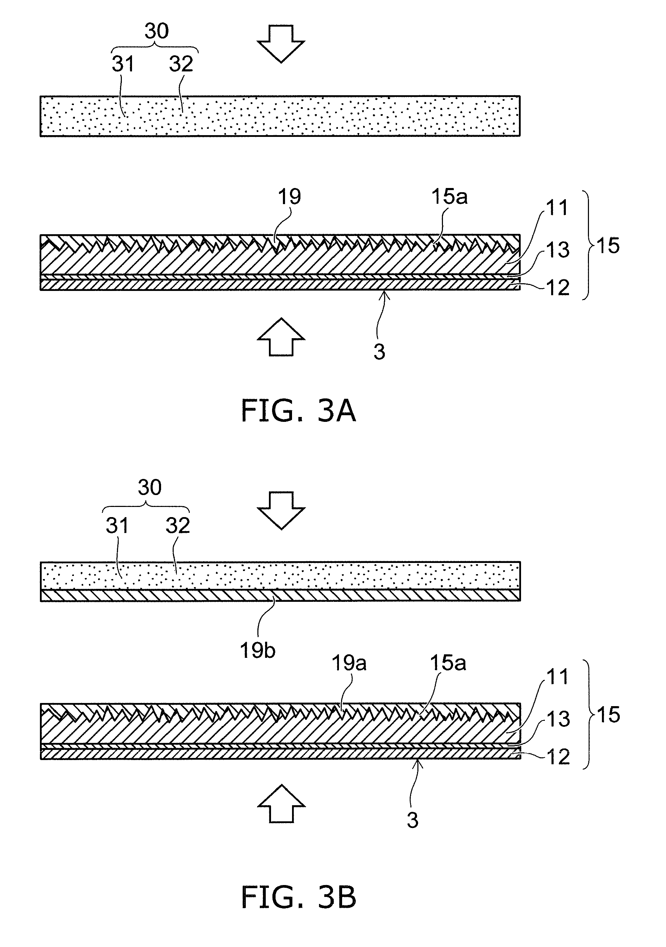

FIG. 3A is a schematic sectional view showing a method of manufacturing the structure shown in FIG. 1A.

A fluorescent material 31 is added to a glass powder at a predetermined ratio, and the glass powder and the fluorescent materials 31 are uniformly mixed. A mold having a predetermined shape is filled with the mixed powder and the mixed powder is heated and melted at, for example, 600°C to 650°C, and then cooled to form, for example, a sheet-like fluorescent material layer 30. The sheet-like fluorescent material layer 30 may be formed by melting and coating on a separate glass substrate.

A light emitting element 3 including a semiconductor layer 15, an electrode and the like is formed to a wafer form on a substrate and the substrate is removed or thinned. A surface of a first layer 11 has an asperity surface 15a formed by, for example, wet etching using an alkaline solution.

A transparent inorganic material layer 19 is formed on the asperity surface 15a. The transparent inorganic material layer 19 is formed using, for example, a chemical vapor deposition (CVD) method, a sputtering method, a spin on glass (SOG) method or the like, and buries the asperity surface 15a.

After the formation of the transparent inorganic material layer 19, a surface of the transparent inorganic material layer 19 is smoothened using, for example, a chemical mechanical polishing (CMP) method.

Otherwise, low temperature-meltable glass may be supplied as the transparent inorganic material layer 19 on the asperity surface 15a, and then subjected to reflow to smoothen a surface thereof.

When the substrate (single crystalline substrate) for growing the semiconductor layer 15 is a transparent substrate such as gallium nitride sapphire, silicon carbide, or gallium oxide, asperities is formed on the surface of the transparent substrate, and then the semiconductor layer 15 is crystal grown on the transparent substrate. And the transparent substrate is subjected to, for example, thinning of 50 µm or less and surface flattening. Such transparent substrate may be used as the transparent inorganic material layer 19.

Next, the fluorescent material layer 30 is bonded to the smoothened surface of the transparent inorganic material layer 19. The bonding surface of the fluorescent material layer 30 to be bonded to the transparent inorganic material layer 19 is also a flat surface. These flat surfaces (bonding surfaces) are cleaned and subjected to a hydrophilic process, and then bonded together from central portions or end portions thereof and heat-treated at 150°C to 300°C for 30 minutes or longer. Thus, more strong adhesion strength can be obtained.

In this manner, the sheet-like fluorescent material layer 30 is bonded to the wafer-like light emitting element 3, and then the stacked body of the light emitting element 3 and the fluorescent material layer 30 is divided by dicing or the like.

According to the embodiment, in the bonding of the fluorescent material layer 30 to the light emitting element 3, a resin adhesion layer is not interposed between the fluorescent material layer 30 and the light emitting element 3. Therefore, the adhesion layer is not deteriorated by heat of the fluorescent material layer 30.

When a glass member 32 of the fluorescent material layer 30 is directly bonded to the semiconductor layer 15, the surface (adhesion surface) of the semiconductor layer 15 is required to be smoothened. However, in that case, the improvement of the light extraction efficiency by the asperity surface is not obtained.

However, according to the embodiment, the transparent inorganic material layer 19 is formed so as to entirely cover the asperity surface 15a of the semiconductor layer 15. The surface of the transparent inorganic material layer 19 is smoothened, and the fluorescent material layer 30 is bonded to the surface of the transparent inorganic material layer 19. Therefore, the efficiency of light extraction from the semiconductor layer 15 to the fluorescent material layer 30 can be improved and the fluorescent material layer 30 can be securely adhered to the light emitting element 3. Accordingly, according to the embodiment, it is possible to provide a semiconductor light emitting device achieving both high light extraction efficiency and high reliability.

In order to secure high adhesion between the fluorescent material layer 30 and the transparent inorganic material layer 19, the average roughness of the surface of the transparent inorganic material layer 19 and the surface of the fluorescent material layer 30 to be bonded to the transparent inorganic material layer 19 is preferably 0.5 nm or less, and more preferably 0.3 nm or less.

FIG. 1B is a schematic sectional view of another specific example of the semiconductor light emitting device of the embodiment.

FIG. 3B is a schematic sectional view showing a method of manufacturing the semiconductor light emitting device of FIG. 1B.

As shown in FIG. 3B, a first transparent inorganic material layer 19a is formed on an asperity surface 15a and a second transparent inorganic material layer 19b is also formed on the adhesion surface side of a fluorescent material layer 30. The first transparent inorganic material layer 19a and the second transparent inorganic material layer 19b are the same material as the above-described transparent inorganic material layer 19 and can be formed in the same manner.

The surface of the first transparent inorganic material layer 19a and the surface of the second transparent inorganic material layer 19b are smoothened. The semiconductor light emitting device shown in FIG. 1B is obtained by bonding the smoothened surface of the first transparent inorganic material layer 19a and the smoothened surface of the second transparent inorganic material layer 19b together. Accordingly, a transparent inorganic material layer 19 in which the first transparent inorganic material layer 19a and the second transparent inorganic material layer 19b are formed integrally with each other is provided between the asperity surface 15a of a light emitting element 3 and the fluorescent material layer 30.

More strong adhesion strength can be obtained by, for example, performing a heat treatment at 150°C to 300°C for 30 minutes or longer.

Since the first transparent inorganic material layer 19a and the second transparent inorganic material layer 19b formed of the same material are bonded together, stress at the bonding interface can be reduced and the adhesion strength can be increased. In this case, in order to secure high adhesion, the average roughness of the surface of the first transparent inorganic material layer 19a and the average roughness of the surface of the second transparent inorganic material layer 19b are preferably 0.5 nm or less, and more preferably 0.3 nm or less.

The materials of the first transparent inorganic material layer 19a and the second transparent inorganic material layer 19b may be different from each other. In this case, the light (excitation light) emitted from the light emitting layer 13 to the fluorescent material layer 30 is easily taken in when the refractive index of the second transparent inorganic material layer 19b is set higher than the refractive index of the first transparent inorganic material layer 19a and set lower than the refractive index of the glass member 32.

FIG. 1C is a schematic sectional view of a further specific example of the semiconductor light emitting device of the embodiment.

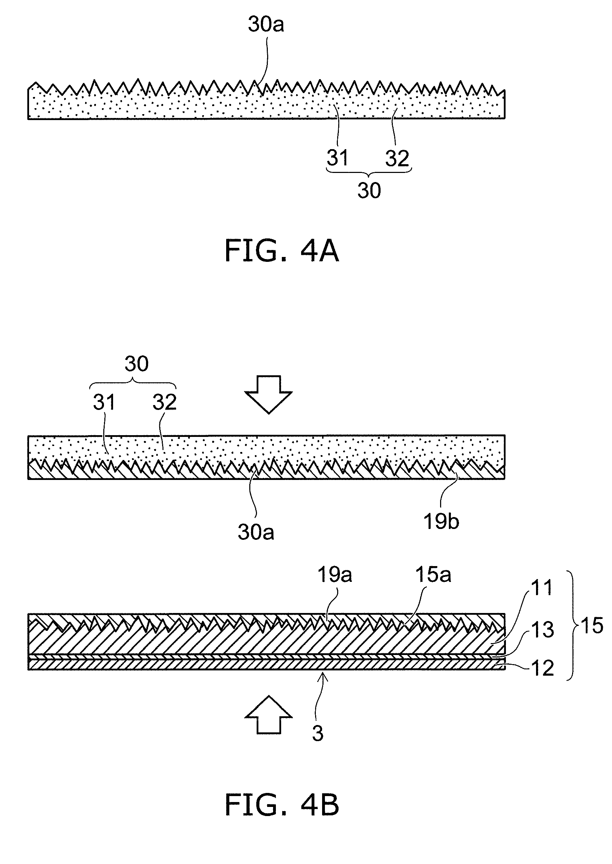

FIGS. 4A and 4B are schematic sectional views showing a method of manufacturing the semiconductor light emitting device of FIG. 1C.

As shown in FIG. 4A, a sheet-like fluorescent material layer 30 in which fluorescent materials 31 are dispersed in a glass member 32 is formed, and then asperities 30a are formed on a surface of the fluorescent material layer 30. For example, by subjecting the glass member 32 to etching, the fluorescent materials 31 can be exposed to the surface of the fluorescent material layer 30 and the asperities 30a can thus be formed. Through etching, the glass member 32 is retracted and formed as concave portions, and the fluorescent materials 31 are exposed as convex portions.

Thereafter, as shown in FIG. 4B, a first transparent inorganic material layer 19a is formed on an asperity surface 15a of a light emitting element 3, and a second transparent inorganic material layer 19b is formed on an asperity surface 30a of the fluorescent material layer 30. The second transparent inorganic material layer 19b entirely covers the asperities of the fluorescent material layer 30.

Regarding the fluorescent material layer 30 and the second transparent inorganic material layer 19b, a similar configuration can be obtained: by forming the fluorescent material layer 30 by melting and coating on a surface of a separate glass substrate having asperities formed thereon; and by forming the second transparent inorganic material layer 19b due to thinning by polishing the glass substrate. When the second transparent inorganic material layer 19b is formed by thinning the above-described glass substrate, a transparent inorganic material layer formed of the same material as the first transparent inorganic material layer 19a may be provided on the surface of the second transparent inorganic material layer 19b.

The surface of the first transparent inorganic material layer 19a and the surface of the second transparent inorganic material layer 19b are smoothened. The semiconductor light emitting device shown in FIG. 1C is obtained by bonding the smoothened surface of the first transparent inorganic material layer 19a and the smoothened surface of the second transparent inorganic material layer 19b together. Accordingly, a transparent inorganic material layer 19 in which the first transparent inorganic material layer 19a and the second transparent inorganic material layer 19b are formed integrally with each other is provided between the asperity surface 15a of the light emitting element 3 and the asperity surface 30a of the fluorescent material layer 30.

Even in this structure, when the first transparent inorganic material layer 19a and the second transparent inorganic material layer 19b formed of the same material are bonded together, the adhesion strength can be increased. When the materials of the first transparent inorganic material layer 19a and the second transparent inorganic material layer 19b are different from each other, the light (excitation light) emitted from the light emitting layer 13 to the fluorescent material layer 30 is easily taken in when the refractive index of the second transparent inorganic material layer 19b is set higher than the refractive index of the first transparent inorganic material layer 19a and set lower than the refractive index of the glass member 32.

In addition, since asperities are formed in the interface (the surface of the transparent inorganic material layer 19 on the side of the fluorescent material layer 30) between the transparent inorganic material layer 19 and the fluorescent material layer 30, the efficiency of taking light from the transparent inorganic material layer 19 to the glass member 32 of the fluorescent material layer 30 can be improved.

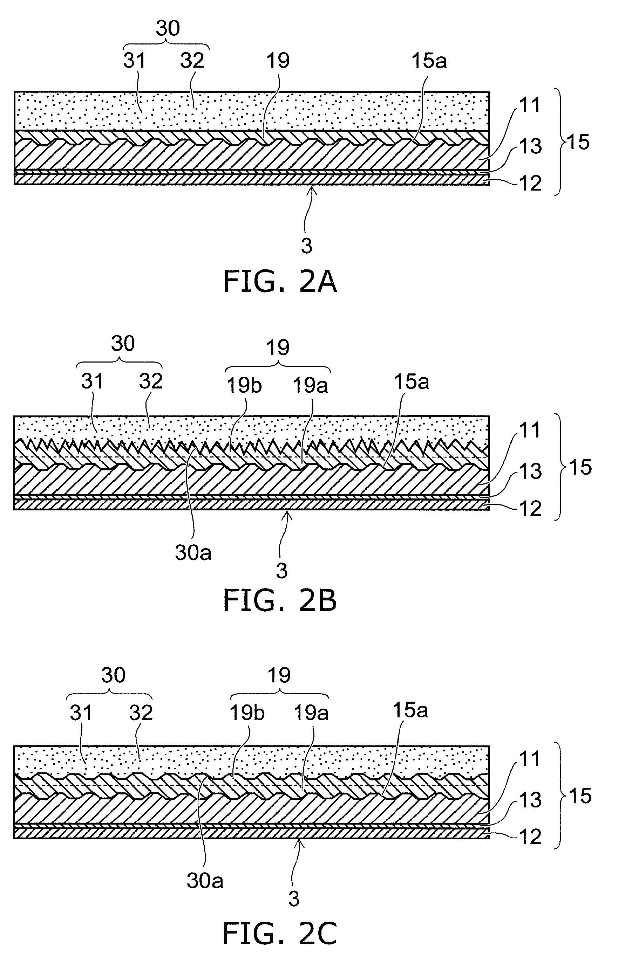

As shown in FIGS. 2A and 2B, the asperity surface 15a may be formed on the semiconductor layer 15 by etching using a mask formed by lithography. As shown in FIG. 2C, the asperity surface 30a may also be formed on the fluorescent material layer 30 by etching using a mask formed by lithography. In this case, asperities having a desired depth, pitch, and width can be formed, and thus optical design is easily facilitated.

In an embodiment, for example, oxide-based fluorescent materials such as Y₃Al₅O₁₂, Ba₂SiO₄:Eu²⁺, and SrBaSiO₄:Eu²⁺, sulfide-based fluorescent materials such as ZnS:(Cu⁺,Al³⁺), SrS:Eu²⁺, CaS:Eu²⁺, and SrGa₂S₄:Eu²⁺, oxysulfide-based fluorescent materials such as Y₂O₂S:Eu³⁺, halide-based fluorescent materials such as M₅(PO₄)₃Cl:Eu²⁺ (where M is Sr, Ca, Ba, or Mg), aluminate-based fluorescent materials such as BaMgAl₁₀O₁₇:(Eu²⁺, Mn²⁺) and SrAl₂O₄:Eu²⁺, and the like can be used as the fluorescent materials 31.

In addition, for example, a material, expressed by the chemical formula: Ca₈₋ₓEuₓMg_{1-y}Mn_{y} (SiO₄)₄Cl₂ (where 0<x≤8, 0≤y≤1), in which Eu is added to calcium magnesium chlorosilicate can be used as the fluorescent material 31. A ratio y of manganese (Mn) is preferably 0 to 0.2.

In addition, for example, strontium silicate-based fluorescent materials expressed by the chemical formula: (Sr₁₋ₓ₋yBa_{y}EUₓ)₃(Si_{1-z}Ge_{z})₅ (where 0<x≤0.1, 0≤y≤1, 0≤z≤0.1) can be used as the fluorescent materials 31.

In addition, for example, sialon-based fluorescent materials expressed by the chemical formula: (M₁₋ₓ,Rₓ)ₐ₁AlSi_{b1}O_{c1}N_{d1} can be used as the fluorescent material 31. Here, M is at least one metal element, except for Si and Al, and preferably at least one of Ca and Sr. R is a light emitting center element, and preferably, for example, Eu. x, a1, b1, c1, and d1 satisfy the following relations: 0<x≤0.1; 0.6<a1<0.95; 2<b1<3.9; 0.25<c1<0.45; and 4<d1<5.7.

In addition, for example, sialon-based fluorescent materials expressed by the chemical formula: (M₁₋ₓ,Rₓ)ₐ₂AlSi_{b2}O_{c2}N_{d2} can be used as the fluorescent materials 31. Here, M is at least one metal element, except for Si and Al, and preferably at least one of Ca and Sr. R is a light emitting center element, and preferably, for example, Eu. x, a2, b2, c2, and d2 satisfy the following relations: 0<x≤1; 0.93<a2<1.3; 4.0<b2<5.8; 0.6<c2<1; and 6<d2<11.

Needless to say, the fluorescent material 31 may include fluorescent material other than the above-described fluorescent material, and a single fluorescent material or a mixture of a plurality kinds of fluorescent materials may be used.

Next, a more detailed, specific example of the semiconductor light emitting device of the embodiment will be described.

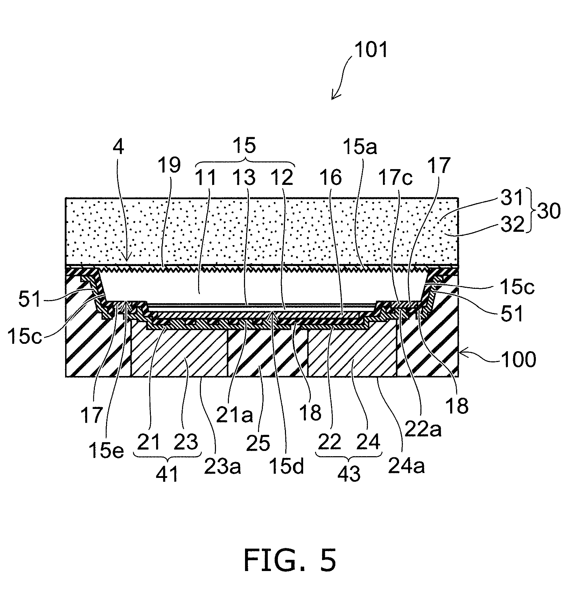

FIG. 5 is a schematic sectional view of a semiconductor light emitting device 101 of an embodiment.

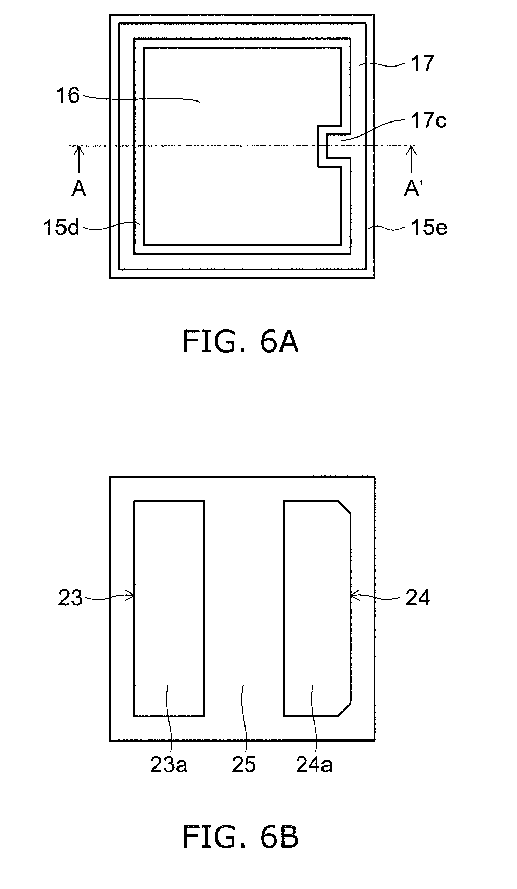

FIG. 6A is a schematic plan view showing an example of a plane layout of some elements in the semiconductor light emitting device 101. FIG. 5 corresponds to the cross-section taken along the line A-A' of FIG. 6A.

FIG. 6B is a schematic plan view of a mounting surface (lower surface in FIG. 5) of the semiconductor light emitting device 101.

The semiconductor light emitting device 101 has a support 100, a fluorescent material layer 30, and a light emitting element 4 which is provided between the support 100 and the fluorescent material layer 30 and includes a semiconductor layer 15.

As described above, the semiconductor layer 15 has a first layer 11, a second layer 12, and a light emitting layer 13 provided between the first layer 11 and the second layer 12. The first layer 11 has an asperity surface 15a.

The semiconductor layer 15 has a part 15d which includes the light emitting layer 13 and the second layer 12, and a part 15e which does not include the light emitting layer 13 and the second layer 12. The light emitting layer 13 is stacked at the part 15d. The light emitting layer 13 is not stacked at the part 15e.

A p-side electrode 16A is provided on a surface of the second layer 12 of the part 15d including the light emitting layer 13. An n-side electrode 17A is provided on a surface of the first layer 11 of the part 15e not including the light emitting layer 13. The p-side electrode 16 and the n-side electrode 17 are provided on the side opposite to the asperity surface 15a.

In the example shown in FIG. 6A, the part 15e not including the light emitting layer 13 surrounds the part 15d including the light emitting layer 13, and the n-side electrode 17 surrounds the p-side electrode 16.

The area of the part 15d including the light emitting layer 13 is larger than the area of the part 15e not including the light emitting layer 13. The area of the p-side electrode 16 provided on the surface of the part 15d including the light emitting layer 13 is larger than the area of the n-side electrode 17 provided on the surface of the part 15e not including the light emitting layer 13. Accordingly, a wide light emitting surface is obtained, and thus the optical output can be increased.

As shown in FIG. 6A, the n-side electrode 17 has, for example, four linear portions. A contact portion 17c is provided on one of the linear portions. The contact portion 17c protrudes in a width direction of the linear portion. As shown in FIG. 5, a via 22a of an n-side interconnection layer 22 is connected to a surface of the contact portion 17c.

The support 100 is provided on the side opposite to the asperity surface 15a in the semiconductor layer 15. The light emitting element 4 including the semiconductor layer 15, the p-side electrode 16 and the n-side electrode 17 is supported by the support 100.

The fluorescent material layer 30 is provided on the asperity surface 15a side of the semiconductor layer 15. As described above, the fluorescent material layer 30 has a glass member 32 and a fluorescent materials 31 dispersed in the glass member 32.

A transparent inorganic material layer 19 is provided between the asperity surface 15a of the semiconductor layer 15 and the fluorescent material layer 30. As the stacked structure of the semiconductor layer 15, the transparent inorganic material layer 19, and the fluorescent material layer 30, any of the above-described structures of FIGS. 1A to 1C and 2A to 2C is applied.

An insulating film 18 covers the side opposite to the asperity surface 15a of the semiconductor layer 15. The insulating film 18 covers a second surface side of the semiconductor layer 15. The insulating film 18 covers the p-side electrode 16 and the n-side electrode 17. The insulating film 18 is an inorganic insulating film such as a silicon oxide film. The insulating film 18 is provided on a side surface of the light emitting layer 13 and a side surface of the second layer 12. The insulating film 18 covers a side surface of the light emitting layer 13 and a side surface of the second layer 12. The insulating film 18 is provided on a side surface 15c extending from the asperity surface 15a of the first layer 11. The insulating film 18 covers the side surface 15c.

A p-side interconnection layer 21 and an n-side interconnection layer 22 are provided to be separated from each other on the insulating film 18. A plurality of first openings communicating with the p-side electrode 16 and a second opening communicating with a contact portion 17c of the n-side electrode 17 are formed in the insulating film 18. The first opening may be one larger opening.

The p-side interconnection layer 21 is provided on the insulating film 18 and inside the first opening. The p-side interconnection layer 21 is electrically connected to the p-side electrode 16 through the via 21a provided in the first opening.

The n-side interconnection layer 22 is provided on the insulating film 18 and inside the second opening. The n-side interconnection layer 22 is electrically connected to the contact portion 17c of the n-side electrode 17 through the via 22a provided in the second opening.

The p-side interconnection layer 21 and the n-side interconnection layer 22 occupy most region on the second surface side of the semiconductor layer 15, and spread on the insulating film 18. The p-side interconnection layer 21 is connected to the p-side electrode 16 through the plurality of vias 21a.

A reflection film 51 covers the side surface 15c of the semiconductor layer 15 via the insulating film 18. The reflection film 51 is not in contact with the side surface 15c, and not electrically connected to the semiconductor layer 15. The reflection film 51 is separated from the p-side interconnection layer 21 and the n-side interconnection layer 22. The reflection film 51 is a metal film which is reflective to the light emitted from the light emitting layer 13 and the light emitted from the fluorescent materials 31.

The reflection film 51, the p-side interconnection layer 21, and the n-side interconnection layer 22 are simultaneously formed on a common metal film using, for example, a plating method. The reflection film 51, the p-side interconnection layer 21, and the n-side interconnection layer 22 include, for example, a copper film. The copper film is formed using a plating method on a metal film formed on the insulating film 18.

The metal film which is a base of the p-side interconnection layer 21 and the n-side interconnection layer 22 includes, for example, an aluminum film. An aluminum film has high reflectance with respect to the light emitted from the light emitting layer 13. The aluminum film is formed to spread in most region on the second surface side of the semiconductor layer 15. Accordingly, the intensity of the light toward the fluorescent material layer 30 can be increased.

A p-side metal pillar 23A is provided on a surface of the p-side interconnection layer 21 opposite to the semiconductor layer 15. A p-side interconnection portion 41 includes the p-side interconnection layer 21 and the p-side metal pillar 23.

An n-side metal pillar 24A is provided on a surface of the n-side interconnection layer 22 opposite to the semiconductor layer 15. An n-side interconnection portion 43 includes the n-side interconnection layer 22 and the n-side metal pillar 24.

A resin layer 25 as an insulating layer is provided between the p-side interconnection portion 41 and the n-side interconnection portion 43. The resin layer 25 is provided on a side surface of the p-side interconnection portion 41 and on a side surface of the n-side interconnection portion 43.

The resin layer 25 is provided between the p-side metal pillar 23 and the n-side metal pillar 24 so as to be in contact with a side surface of the p-side metal pillar 23 and a side surface of the n-side metal pillar 24. The resin layer 25 is filled between the p-side metal pillar 23 and the n-side metal pillar 24.

The resin layer 25 is provided between the p-side interconnection layer 21 and the n-side interconnection layer 22, between the p-side interconnection layer 21 and the reflection film 51, and between the n-side interconnection layer 22 and the reflection film 51. The resin layer 25 is provided around the p-side metal pillar 23 and around the n-side metal pillar 24, and covers the side surface of the p-side metal pillar 23 and the side surface of the n-side metal pillar 24.

The resin layer 25 is also provided at a region (outer circumferential portion of chip) adjacent to the side surface 15c of the semiconductor layer 15, and covers the reflection film 51.

An end portion (surface) of the p-side metal pillar 23 on the side opposite to the p-side interconnection layer 21 functions as a p-side external terminal 23a. The p-side external terminal 23a is exposed from the resin layer 25 and capable of being connected to an external circuit such as a mounting substrate. An end portion (surface) of the n-side metal pillar 24 on the side opposite to the n-side interconnection layer 22 functions as an n-side external terminal 24a. The n-side external terminal 24a is exposed from the resin layer 25 and capable of being connected to an external circuit such as a mounting substrate. The p-side external terminal 23a and the n-side external terminal 24a are bonded to a pad of a mounting substrate via, for example, solder or a conductive bonding member.

As shown in FIG. 6B, the p-side external terminal 23a and the n-side external terminal 24a are formed side by side with an interval therebetween in the same plane of the resin layer 25. The p-side external terminal 23a is formed in, for example, a rectangular shape, and the n-side external terminal 24a is formed in a shape in which two angles of a rectangular shape having the same size as the rectangular shape of the p-side external terminal 23a are cut. Accordingly, the polarity of the external terminal can be discriminated. The n-side external terminal 24a may have a rectangular shape and the p-side external terminal 23a may have a shape in which angles of a rectangular shape are cut.

The interval between the p-side external terminal 23a and the n-side external terminal 24a is larger than the interval between the p-side interconnection layer 21 and the n-side interconnection layer 22 on the insulating film 18. The interval between the p-side external terminal 23a and the n-side external terminal 24a is set larger than the spread of solder at the mounting. Accordingly, a short circuit between the p-side external terminal 23a and the n-side external terminal 24a through the solder can be prevented.

The interval between the p-side interconnection layer 21 and the n-side interconnection layer 22 can be reduced up to the limit on the process. Therefore, the area of the p-side interconnection layer 21 and the contact area between the p-side interconnection layer 21 and the p-side metal pillar 23 are increased. Accordingly, the emission of heat of the light emitting layer 13 can be promoted.

The area where the p-side interconnection layer 21 is in contact with the p-side electrode 16 through the plurality of vias 21a is larger than the area where the n-side interconnection layer 22 is in contact with the n-side electrode 17 through the via 22a. Accordingly, the distribution of an electric current flowing to the light emitting layer 13 can be uniformized.

The area of the n-side interconnection layer 22 spreading on the insulating film 18 can be set larger than the area of the n-side electrode 17. In addition, the area of the n-side metal pillar 24 (the area of the n-side external terminal 24a) provided on the n-side interconnection layer 22 can be set larger than the area of the n-side electrode 17. Accordingly, it is possible to reduce the area of the n-side electrode 17 while securing the area of the n-side external terminal 24a sufficient for mounting with high reliability. That is, the optical output can be improved by reducing the area of the part 15e not including the light emitting layer 13 and by increasing the area of the part 15d including the light emitting layer 13 in the semiconductor layer 15.

The first layer 11 is electrically connected to the n-side metal pillar 24 via the n-side electrode 17 and the n-side interconnection layer 22. The second layer 12 is electrically connected to the p-side metal pillar 23 via the p-side electrode 16 and the p-side interconnection layer 21.

The thickness of the p-side metal pillar 23 (the thickness in a direction connecting the p-side interconnection layer 21 and the p-side external terminal 23a) is larger than the thickness of the p-side interconnection layer 21. The thickness of the n-side metal pillar 24 (the thickness in a direction connecting the n-side interconnection layer 22 and the n-side external terminal 24a) is larger than the thickness of the n-side interconnection layer 22. The thickness of each of the p-side metal pillar 23, the n-side metal pillar 24, and the resin layer 25 is larger than the thickness of the semiconductor layer 15.

The aspect ratio (the ratio of a thickness to a plane size) of the metal pillars 23 and 24 may be 1 or higher, or lower than 1. That is, the thickness of the metal pillars 23 and 24 may be larger or smaller than a plane size thereof.

The thickness of the support 100 including the p-side interconnection layer 21, the n-side interconnection layer 22, the p-side metal pillar 23, the n-side metal pillar 24, and the resin layer 25 is larger than the thickness of the light emitting element (LED chip) 4 including the semiconductor layer 15, the p-side electrode 16, and the n-side electrode 17.

The semiconductor layer 15 is formed on a substrate using an epitaxial growth method. In the example shown in FIG. 5, the substrate is removed after the formation of the support 100, and thus the semiconductor layer 15 does not include the substrate on the asperity surface 15a side. The semiconductor layer 15 is not supported by a rigid, plate-like substrate, but by the support 100 formed of a combination of the metal pillars 23 and 24 and the resin layer 25.

As the material of the p-side interconnection portion 41 and the n-side interconnection portion 43, for example, copper, gold, nickel, silver or the like can be used. Among these, when copper is used, it is possible to obtain superior thermal conductivity, high migration resistance, and improved adhesion to an insulating material.

The resin layer 25 reinforces the p-side metal pillar 23 and the n-side metal pillar 24. The coefficient of thermal expansion of the resin layer 25 is preferably the same as or close to that of the mounting substrate. Examples of the resin layer 25 include resins mainly including an epoxy resin, resins mainly including a silicone resin, and resins mainly including a fluororesin.

The resin which is a base of the resin layer 25 may contain a light absorber, a light reflection material, a light scattering agent or the like. The resin layer 25 has a light shielding property or reflectivity with respect to the light of the light emitting layer 13. Accordingly, light leakage from the side surface of the support 100 and from the mounting surface can be suppressed.

Due to the thermal cycle at the mounting the semiconductor light emitting device, the stress caused by solder or the like for bonding the p-side external terminal 23a and the n-side external terminal 24a to a pad of the mounting substrate is applied to the semiconductor layer 15. The p-side metal pillar 23, the n-side metal pillar 24, and the resin layer 25 absorb and relax the stress. Particularly, the stress relaxation effect can be increased using the resin layer 25, which is more flexible than the semiconductor layer 15, as a part of the support 100.

The reflection film 51 is separated from the p-side interconnection portion 41 and the n-side interconnection portion 43. Therefore, the stress applied to the p-side metal pillar 23 and the n-side metal pillar 24 at the mounting is not transferred to the reflection film 51. Accordingly, the peeling of the reflection film 51 can be suppressed. In addition, the stress applied to the side surface 15c of the semiconductor layer 15 can be suppressed.

After the substrate is removed and the asperity surface 15a is formed, the transparent inorganic material layer 19 is formed on the asperity surface 15a. The transparent inorganic material layer 19 is also formed on the insulating film 18 at the outer circumferential portion of the chip. The surface of the transparent inorganic film 19 is smoothened and the fluorescent material layer 30 is bonded to the smoothened surface of the transparent inorganic material layer 19.

The fluorescent material layer 30 is not formed around the second surface side of the semiconductor layer 15, the metal pillars 23 and 24, and the side surface of the support 100. The side surface of the fluorescent material layer 30 and the side surface of the support 100 (the side surface of the resin layer 25) are aligned.

That is, the semiconductor light emitting device 101 shown in FIG. 5 is a very small semiconductor light emitting device having a chip-size package structure.

The fluorescent material layer 30 is not uselessly formed on the mounting surface side on which light is not extracted to the outside, and thus cost reduction is achieved. The heat of the light emitting layer 13 can be emitted to the mounting substrate via the p-side interconnection layer 21 and the n-side interconnection layer 22 spreading on the second surface side and the thick metal pillars 23 and 24, and thus a small semiconductor light emitting device having an excellent heat radiation property is obtained.

In general flip chip mounting, an LED chip is mounted on a mounting substrate via bumps or the like, and then a fluorescent material layer is formed to cover the entire chip. Or, a resin is underfilled between the bumps.

However, according to the embodiment, the resin layer 25 which is different from the fluorescent material layer 30 is provided around the p-side metal pillar 23 and around the n-side metal pillar 24 in a state before mounting, and thus characteristics suitable for stress relaxation can be imparted to the mounting surface. In addition, since the resin layer 25 is provided already on the mounting surface side, underfilling after the mounting is not required.

The fluorescent material layer 30 designed to give priority to the light extraction efficiency, color conversion efficiency, light distribution characteristics and the like is provided on the side of the asperity surface (first surface) 15a, and a layer designed to give priority to the stress relaxation at the mounting and characteristics as a support which is a substitute for the substrate is provided on the mounting surface side. For example, the resin layer 25 can be densely filled with a filler such as silica particles to adjust its hardness to appropriate hardness as a support.

The light emitted from the light emitting layer 13 to the asperity surface 15a enters the fluorescent material layer 30 via the transparent inorganic material layer 19. A part of the light excites the fluorescent materials 31, and for example, pseudo white light as mixed light of the light of the light emitting layer 13 and the light of the fluorescent materials 31 is obtained.

Here, when a substrate is provided on the asperity surface 15a, light which does not enter the fluorescent material layer 30, but leaks to the outside from a side surface of the substrate is generated. That is, strong-colored light which is light of the light emitting layer 13 leaks from the side surface of the substrate, and thus when the fluorescent material layer 30 is viewed from the upper surface, color breakup or color unevenness such as a phenomenon in which a blue light ring is seen on the outer edge side may be caused.

However, according to the embodiment, since there is no substrate between the asperity surface 15a and the fluorescent material layer 30, color breakup or color unevenness caused due to the leakage of strong-colored light which is light of the light emitting layer 13 from the side surface of the substrate can be prevented.

The reflection film 51 is provided on the side surface 15c of the first layer 11 via the insulating film 18. The light from the light emitting layer 13 toward the side surface 15c of the first layer 11 is reflected by the reflection film 51 and does not leak to the outside. Therefore, together with the characteristic in which there is no substrate on the side of the asperity surface 15a, color breakup or color unevenness caused due to the light leakage from the side surface side of the semiconductor light emitting device can be prevented.

The insulating film 18 provided between the reflection film 51 and the side surface 15c of the first layer 11 prevents the diffusion of the metal contained in the reflection film 51 to the first layer 11. Accordingly, for example, metal contamination of GaN contained in the first layer 11 can be prevented, and thus a deterioration of the first layer 11 can be prevented.

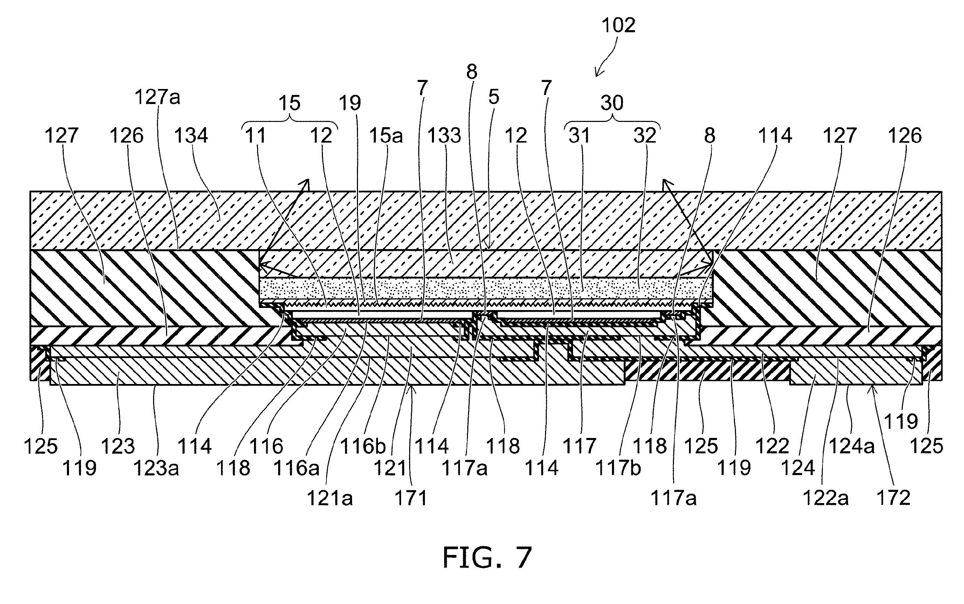

Next, a further specific example of the semiconductor light emitting device of the embodiment will be described with reference to FIGS. 7 to 9.

FIG. 7 is a schematic sectional view of a semiconductor light emitting device 102 of the embodiment.

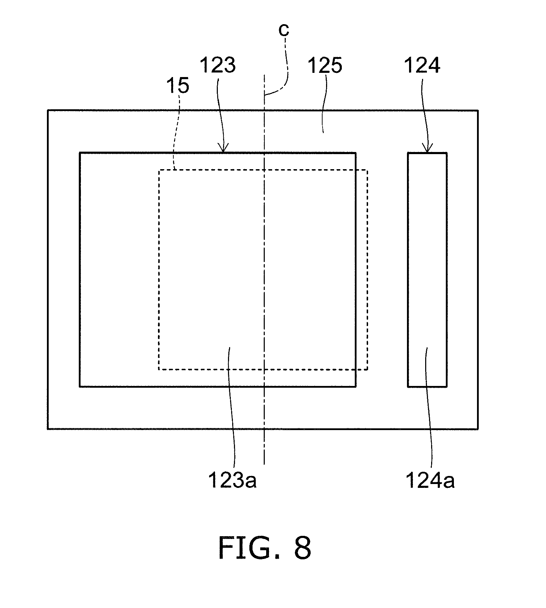

FIG. 8 is a schematic plan view of the mounting surface side of the semiconductor light emitting device 102 of the embodiment, and corresponds to the bottom view of FIG. 7.

The semiconductor light emitting device 102 has a chip-sized light emitting element (LED chip) 5 formed at a wafer level, an insulating member 127 provided around the light emitting element 5, and metal layers 171 and 172 provided on the mounting surface side.

The light emitting element 5 has electrodes 7 and 8, first interconnection layers (on-chip interconnection layers) 116 and 117, optical layers 30 and 133, and a semiconductor layer 15 provided between the first interconnection layers 116 and 117 and the optical layers 30 and 133.

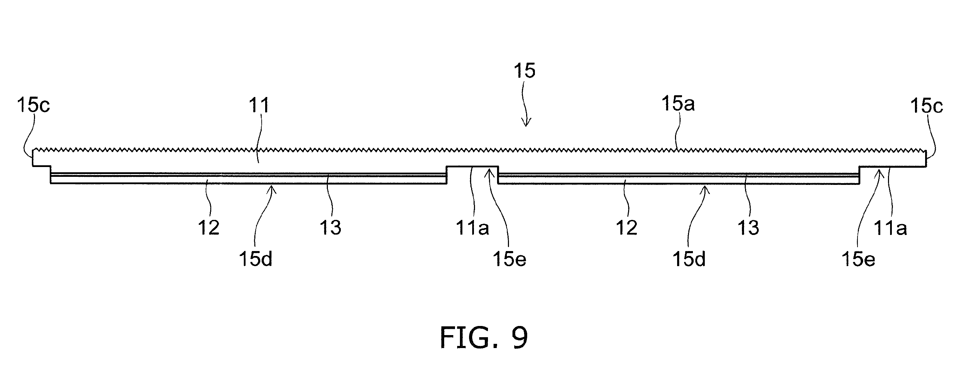

FIG. 9 is an enlarged, schematic sectional view of the semiconductor layer 15.

As described above, the semiconductor layer 15 has a first layer 11, a second layer 12, and a light emitting layer 13 provided between the first layer 11 and the second layer 12.

The semiconductor layer 15 has a region 15d having stacked films of the second layer 12 and the light emitting layer 13, and a region 15e having a second surface 11a of the first layer 11 which is not covered with the light emitting layer 13 and the second layer 12.

For example, the region 15e is formed in an island shape surrounded by the light emitting region 15d, and is formed to continuously surround the light emitting region 15d on the outer circumferential side of the light emitting region 15d. The light emitting region 15d has a larger area than the region 15e.

An asperity surface (first surface) 15a which is not covered with the light emitting layer 13 and the second layer 12 is formed on the side opposite to the second surface 11a of the first layer 11. In addition, the semiconductor layer 15 has a side surface 15c extending to the asperity surface 15a.

The n-side electrode 8 shown in FIG. 7 is provided on the second surface 11a of the first layer 11. The p-side electrode 7 shown in FIG. 7 is provided on a surface of the second layer 12. The p-side electrode 7 and the n-side electrode 8 are provided within a range of the region (chip region) overlapping with the semiconductor layer 15.

The p-side electrode 7 has a larger area than the n-side electrode 8.

The contact area between the p-side electrode 7 and the second layer 12 is larger than the contact area between the n-side electrode 7 and the first layer 11.

An insulating film 114A is provided on a surface of the semiconductor layer 15 other than the asperity surface 15a. The insulating film 114 is an inorganic film and is, for example, a silicon oxide film.

A p-side opening communicating with the p-side electrode 7 and an n-side opening communicating with the n-side electrode 8 are formed in the insulating film 114. For example, two n-side openings are formed to be separated from each other. A surface of the p-side electrode 7 between the two n-side openings is covered with the insulating film 114.

The side surface 15c of the first layer 11, the side surface of the second layer 12, and the side surface of the light emitting layer 13 are covered with the insulating film 114.

A first p-side interconnection layer 116 and a first n-side interconnection layer 117 are provided on the side opposite to the asperity surface 15a of the semiconductor layer 15.

The first p-side interconnection layer 116 is provided within a range of the region (chip region) overlapping with the semiconductor layer 15. The first p-side interconnection layer 116 is also provided inside the p-side opening and is in contact with the p-side electrode 7. The first p-side interconnection layer 116 is connected to the p-side electrode 7 via a contact portion 116a integrally formed in the p-side opening. The first p-side interconnection layer 116 is not in contact with the first layer 11.

The first n-side interconnection layer 117 is provided within a range of the region (chip region) overlapping with the semiconductor layer 15. The first n-side interconnection layer 117 is also provided inside the n-side opening and is in contact with the n-side electrode 8. The first n-side interconnection layer 117 is connected to the n-side electrode 8 via a contact portion 117a integrally formed in the n-side opening.

The first n-side interconnection layer 117 is formed in, for example, a line pattern extending in a direction connecting two island-like n-side electrodes 8. The insulating film 114 is provided between the part between the two n-side electrodes 8 of the first n-side interconnection layer 117 and the p-side electrode 7. The insulating film 114 is provided between the part between the two n-side electrodes 8 of the first n-side interconnection layer 117 and the second layer 12. The first n-side interconnection layer 117 is not in contact with the p-side electrode 7 and the second layer 12.

The p-side electrode 7 is provided between the second layer 12 and the first p-side interconnection layer 116. For example, the p-side electrode 7 includes a silver (Ag) film having high reflectance with respect to the light emitted from the light emitting layer 13 and the fluorescent materials 31.

The n-side electrode 8 is provided between the first layer 11 and the contact portion 117a of the first n-side interconnection layer 117. For example, the n-side electrode 8 includes an aluminum (Al) film having high reflectance with respect to the light emitted from the light emitting layer 13 and the fluorescent materials 31.

An insulating film 118 is provided on surfaces of the first p-side interconnection layer 116 and the first n-side interconnection layer 117. The insulating film 118 is also provided between the first p-side interconnection layer 116 and the first n-side interconnection layer 117. The insulating film 118 is, for example, an inorganic film such as a silicon oxide film.

A p-side opening which exposes a part (p-side pad 116b) of the first p-side interconnection layer 116 and an n-side opening which exposes a part (n-side pad 117b) of the first n-side interconnection layer 117 are formed in the insulating film 118.

The area of the p-side pad 116b is larger than the area of the n-side pad 117b. The area of the n-side pad 117b is larger than the contact area between the first n-side interconnection layer 117 and the n-side electrode 8.

The fluorescent material layer 30 is provided on the asperity surface 15a of the semiconductor layer 15, and the transparent layer (first transparent layer) 133 is provided on the fluorescent material layer 30. As described above, the fluorescent material layer 30 has a glass member 32 and fluorescent materials 31 dispersed in the glass member 32.

A transparent inorganic material layer 19 is provided between the asperity surface 15a and the fluorescent material layer 30. In the semiconductor light emitting device 102 of FIG. 7, as the stacked structure of the semiconductor layer 15, the transparent inorganic material layer 19, and the fluorescent material layer 30, any of the above-described structures of FIGS. 1A to 1C and 2A to 2C is applied.

The transparent inorganic material layer 19 and the fluorescent material layer 30 are also provided on the insulating film 114 at a region outside the chip.

A transparent glass or a transparent resin which does not contain fluorescent material particles is used as the transparent layer 133 on the fluorescent material layer 30. When the transparent layer 133 is allowed to function as a light-scattering layer, the transparent layer 133 includes a scattering material particles (for example, silicon oxide, titanium compound, zinc oxide or the like), which scatters the light emitted from the light emitting layer 13, and a binder (for example, a transparent resin or transparent glass) which transmits the light emitted from the light emitting layer 13.

The insulating member 127 is provided at a region outside the chip on the outside of the side surface of the semiconductor layer 15. The insulating member 127 is thicker than the semiconductor layer 15. The insulating member 127 covers the side surface of the semiconductor layer 15 via the insulating film 114.

The insulating member 127 is also provided on the outside of the side surfaces of the optical layers (fluorescent material layer 30 and transparent layer 33) and covers the side surfaces of the optical layers.

The insulating member 127 is provided around and supports the light emitting element 5 including the semiconductor layer 15, the electrodes 7 and 8, the first interconnection layers (on-chip interconnection layers) 116 and 117, and the fluorescent material layer 30.

An upper surface 127a of the insulating member 127 and an upper surface of the transparent layer 133 form a flat surface. An insulating film 126 is provided on the back surface of the insulating member 127.

A second p-side interconnection layer 121 is provided on the first p-side pad 116b of the first p-side interconnection layer 116. The second p-side interconnection layer 121 is in contact with the first p-side pad 116b of the first p-side interconnection layer 116, and extends to the region outside the chip. A part extending to the region outside the chip of the second p-side interconnection layer 121 is supported by the insulating member 127 via the insulating film 126.

A part of the second p-side interconnection layer 121 also extends to a region overlapping with the first n-side interconnection layer 117 via the insulating film 118.

A second n-side interconnection layer 122 is provided on the first n-side pad 117b of the first n-side interconnection layer 117. The second n-side interconnection layer 122 is in contact with the first n-side pad 117b of the first n-side interconnection layer 117, and extends to the region outside the chip. A part extending to the region outside the chip in the second n-side interconnection layer 122 is supported by the insulating member 127 via the insulating film 126.

An insulating film 119 is provided on surfaces of the second p-side interconnection layer 121 and the second n-side interconnection layer 122. The insulating film 119 is, for example, an inorganic film such as a silicon oxide film.

A p-side opening which exposes a second p-side pad 121a of the second p-side interconnection layer 121 and an n-side opening which exposes a second n-side pad 122a of the second n-side interconnection layer 122 are formed in the insulating film 119.

A p-side external connection electrode 123 is provided on the second p-side pad 121a of the second p-side interconnection layer 121. The p-side external connection electrode 123 is provided on the second p-side interconnection layer 121 in contact with the second p-side pad 121a of the second p-side interconnection layer 121.

A part of the p-side external connection electrode 123 is also provided in a region overlapping with the first n-side interconnection layer 117 via the insulating films 118 and 119, and in a region overlapping with the second n-side interconnection layer 122 via the insulating film 119.

The p-side external connection electrode 123 spreads to the chip region overlapping with the semiconductor layer 15 and to the region outside the chip. The p-side external connection electrode 123 is thicker than the first p-side interconnection layer 116 and the second p-side interconnection layer 121.

An n-side external connection electrode 124 is provided on the second n-side pad 122a of the second n-side interconnection layer 122. The n-side external connection electrode 124 is disposed in the region outside the chip and is in contact with the second n-side pad 122a of the second n-side interconnection layer 122.

The n-side external connection electrode 124 is thicker than the first n-side interconnection layer 117 and the second n-side interconnection layer 122.

A resin layer (insulating layer) 125 is provided between the p-side external connection electrode 123 and the n-side external connection electrode 124. The resin layer 125 is filled between the p-side external connection electrode 123 and the n-side external connection electrode 124 in contact with a side surface of the p-side external connection electrode 123 and a side surface of the n-side external connection electrode 124.

In addition, the resin layer 125 is provided around the p-side external connection electrode 123 and around the n-side external connection electrode 124, and covers the side surface of the p-side external connection electrode 123 and the side surface of the n-side external connection electrode 124.

The resin layer 125 increases the mechanical strength of the p-side external connection electrode 123 and the n-side external connection electrode 124. The resin layer 125 functions as a solder resist for preventing wet spreading of solder at the mounting.

A lower surface of the p-side external connection electrode 123 functions as a p-side mounting surface (p-side external terminal) 123a which is exposed from the resin layer 125 and capable of being connected to an external circuit such as a mounting substrate.

A lower surface of the n-side external connection electrode 124 functions as an n-side mounting surface (n-side external terminal) 124a which is exposed from the resin layer 125 and capable of being connected to an external circuit such as a mounting substrate.

The p-side mounting surface 123a and the n-side mounting surface 124a are bonded to a land pattern of a mounting substrate via, for example, solder or a conductive bonding member.

The p-side mounting surface 123a and the n-side mounting surface 124a preferably protrude from the surface of the resin layer 125. Accordingly, the solder shape of the contact portion at the mounting can be stabilized and mounting reliability can be improved.

FIG. 8 shows an example of a plane layout of the p-side mounting surface 123a and the n-side mounting surface 124a.

The p-side mounting surface 123a and the n-side mounting surface 124a are disposed asymmetrically with respect to a central line c which divides the plane region of the semiconductor layer 15 in half, and the p-side mounting surface 123a is wider than the n-side mounting surface 24a.

The interval between the p-side mounting surface 123a and the n-side mounting surface 124a is set so that solder does not bridge a gap between the p-side mounting surface 123a and the n-side mounting surface 124a at the mounting.

An n-side electrode contact surface (second surface 11a of first layer 11) of the semiconductor layer 15 is reallocated in a wider region including the region outside the chip by the first n-side interconnection layer 117 and the second n-side interconnection layer 122. Accordingly, it is possible to reduce the area of the n-side electrode surface of the semiconductor layer 15 while securing the area of the n-side mounting surface 124a sufficient for mounting with high reliability. Accordingly, the optical output can be improved by reducing the area of the region 15e not including the light emitting layer 13 and by increasing the area of the region 15d including the light emitting layer 13 of the semiconductor layer 15.

The p-side metal layer 171 and the n-side metal layer 172 are provided on the mounting surface side. The p-side metal layer 171 includes the first p-side interconnection layer 116, the second p-side interconnection layer 121, and the p-side external connection electrode 123. The n-side metal layer 172 includes the first n-side interconnection layer 117, the second n-side interconnection layer 122, and the n-side external connection electrode 124.

The semiconductor layer 15 is supported on a support formed of a combination of the metal layers 171 and 172 and the resin layer 125. The semiconductor layer 15 is supported from the side surface side by the insulating member 127 which is, for example, a resin layer thicker than the semiconductor layer 15

As the material of the metal layers 171 and 172, for example, copper, gold, nickel, silver or the like can be used. Among these, when copper is used, it is possible to obtain superior thermal conductivity, high migration resistance, and improved adhesion to an insulating material.

Due to the thermal cycle at the mounting the semiconductor light emitting device, the stress caused by solder or the like for bonding the p-side mounting surface 123a and the n-side mounting surface 124a to a land of the mounting substrate is applied to the semiconductor layer 15. When the p-side external connection electrode 123, the n-side external connection electrode 124, and the resin layer 125 are formed to have an appropriate thickness (height), the p-side external connection electrode 123, the n-side external connection electrode 124, and the resin layer 125 absorb and relax the stress. Particularly, the stress relaxation effect can be increased using the resin layer 125, which is more flexible than the semiconductor layer 15, as a part of the support on the mounting surface side.

The metal layers 171 and 172 contains, for example, copper having a high coefficient of thermal conductivity as a main component, and thus a high thermal conductive member spreads in a wide area in a region overlapping with the light emitting layer 13. The heat generated in the light emitting layer 13 is radiated to the mounting substrate through the metal layers 171 and 172 in a short path formed below the chip.

Particularly, since the p-side mounting surface 123a of the p-side metal layer 171 connected to the light emitting region 15d of the semiconductor layer 15 overlaps with most plane region of the semiconductor layer 15 in plan view shown in FIG. 8, heat can be radiated to the mounting substrate through the p-side metal layer 171 with high efficiency.

The p-side mounting surface 123a is also expanded to the region outside the chip. Accordingly, the plane size of solder bonded to the p-side mounting surface 123a can be increased and the heat radiation property to the mounting substrate via solder can be improved.

The second n-side interconnection layer 122 extends to the region outside the chip. Therefore, the n-side mounting surface 124a can be disposed in the region outside the chip without receiving a limitation of the p-side mounting surface 123a laid out to occupy most region overlapping with the chip. When the n-side mounting surface 124a is disposed in the region outside the chip, the area can be increased compared to a case in which the n-side mounting surface 124a is laid out only in the chip region.

Accordingly, at the n-side, the plane size of solder bonded to the n-side mounting surface 124a can be increased and the heat radiation property to the mounting substrate via solder can be improved.

The light emitted from the light emitting layer 13 to the asperity surface 15a enters the fluorescent material layer 30 via the transparent inorganic material layer 19. A part of the light excites the fluorescent materials 31, and for example, white light as mixed light of the light of the light emitting layer 13 and the light of the fluorescent materials 31 is obtained.

The light emitted from the light emitting layer 13 to the mounting surface is reflected by the p-side electrode 7 and the n-side electrode 8 and directed to the upper fluorescent material layer 30.

The transparent layer (first transparent layer) 133 is provided on the fluorescent material layer 30, and a transparent layer (second transparent layer) 134 is provided on the transparent layer 133 and on the insulating member 127 at the region outside the chip.

A transparent glass or a transparent resin is used as the transparent layer 134, and in a case in which the transparent glass is used, an adhesion layer formed of a transparent resin may be inserted. In addition, a scattering material particles (for example, silicon oxide, titanium compound, zinc oxide or the like), which scatters the light emitted from the light emitting layer 13, and a binder (for example, a transparent resin or transparent glass) which transmits the light emitted from the light emitting layer 13 may be included.

In the latter case, the transparent layer 134 functions as a light-scattering layer. The plane size of the transparent layer 134 which is a light-scattering layer is larger than those of the fluorescent material layer 30 and the transparent layer 133. That is, the plane size of the transparent layer 134 is larger than that of the light emitting element 5. Accordingly, the range of light which is emitted to the outside from the semiconductor light emitting device 102 can be widened, and thus wide-angle light distribution characteristics can be obtained.

A surface of a part of the insulating member 127, at least located in proximity to the side surface of the semiconductor layer 15, has reflectivity with respect to the light emitted from the light emitting layer 13. A part located in proximity to the side surface of the fluorescent material layer 30 and a part located in proximity to the side surface of the transparent layer 133 in the insulating member 127 have reflectivity with respect to the light emitted from the light emitting layer 13 and the light emitted from the fluorescent materials 31. A part in the vicinity of a boundary between the insulating member 127 and the transparent layer 134 has reflectivity with respect to the light emitted from the light emitting layer 13 and the light emitted from the fluorescent materials 31.

For example, the insulating member 127 is a resin layer in which reflectance with respect to the light emitted from the light emitting layer 13 and the light emitted from the fluorescent materials 31 is 50% or greater.

Accordingly, the light emitted from the side surface of the light emitting element 5 and the light scattered on the transparent layer 134 toward the insulating member 127 can be reflected by the insulating member 127. Therefore, light absorption loss in the insulating member 127 can be prevented, and thus the efficiency of light extraction through the transparent layer 134 can be improved.

The transparent inorganic material layer 19 is formed on the asperity surface 15a of the semiconductor layer 15 and the surface of the transparent inorganic material layer 19 is smoothened. The fluorescent material layer 30 is bonded to the smoothened surface of the transparent inorganic material layer 19. The plane size of the fluorescent material layer 30 is substantially the same as or slightly larger than the plane size of the semiconductor layer 15.

The fluorescent material layer 30 is not provided around the side surface of the semiconductor layer 15 and the mounting surface side. That is, the fluorescent material layer 30 is not uselessly provided on the chip side surface side and on the mounting surface side on which light is not extracted to the outside, and thus cost reduction is achieved.

The resin layer 125 which is different from the fluorescent material layer 30 is provided around the p-side external connection electrode 123 and around the n-side external connection electrode 124, and thus characteristics suitable for stress relaxation can be imparted to the mounting surface. In addition, since the resin layer 125 is provided already on the mounting surface side, underfilling after the mounting of the semiconductor light emitting device 102 on the mounting substrate is not required.

The fluorescent material layer 30 designed to give priority to the light extraction efficiency, color conversion efficiency, light distribution characteristics and the like is provided on the asperity surface 15a side of the semiconductor layer 15, and a layer designed to give priority to the stress relaxation at the mounting and characteristics as a support which is a substitute for the substrate is provided on the mounting surface side. For example, the resin layer 125 has a structure in which a base resin is densely filled with a filler such as silica particles, and its hardness is adjusted to appropriate hardness as a support.

According to the semiconductor light emitting device 102 shown in FIG. 7, the chip-size light emitting element 5 can be realized at a low cost by collectively forming the semiconductor layer 15, the electrodes 7 and 8, the on-chip interconnection layers 116 and 117, and the fluorescent material layer 30 at a wafer level, and the heat radiation property can be increased by expanding the external terminals (mounting surface) 123a and 124a to the region outside the chip. Accordingly, it is possible to provide a cheap semiconductor light emitting device 102 having high reliability.

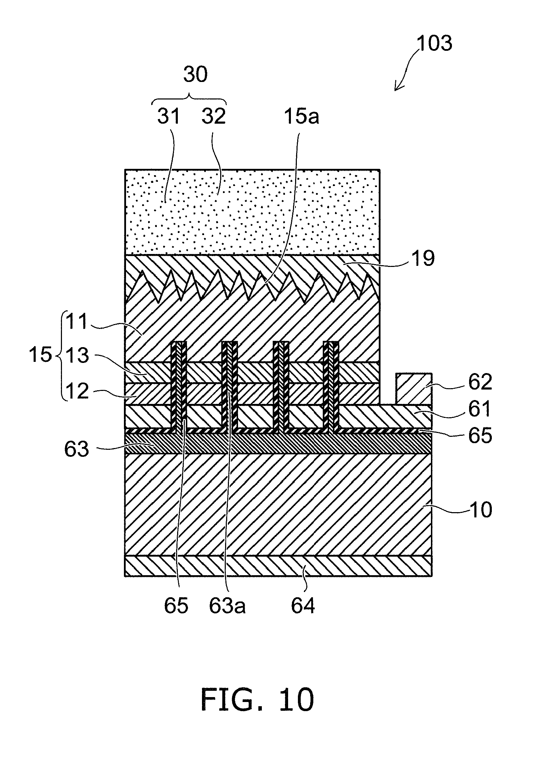

FIG. 10 is a schematic sectional view of a semiconductor light emitting device 103 of a further embodiment.

The semiconductor light emitting device 103 has a support substrate 10, a fluorescent material layer 30, and a semiconductor layer 15 provided between the support substrate 10 and the fluorescent material layer 30.

As described above, the semiconductor layer 15 has a first layer 11, a second layer 12, and a light emitting layer 13 provided between the first layer 11 and the second layer 12. The first layer 11 has an asperity surface 15a.

The support substrate 10 is provided on the side opposite to the asperity surface 15a of the semiconductor layer 15 via a metal layer (bonding metal) 63. A metal layer (back metal) 64 is provided on a back surface of the support substrate 10. The back surface is opposite to the surface on which the metal layer 63 is provided.

The fluorescent material layer 30 is provided on the asperity surface 15a side of the semiconductor layer 15. As described above, the fluorescent material layer 30 has a glass member 32 and fluorescent materials 31 dispersed in the glass member 32.

A transparent inorganic material layer 19 is provided between the asperity surface 15a of the semiconductor layer 15 and the fluorescent material layer 30. As the stacked structure of the semiconductor layer 15, the transparent inorganic material layer 19, and the fluorescent material layer 30, any of the above-described structures of FIGS. 1A to 1C and 2A to 2C is applied.

A p-side electrode 61 is provided between the semiconductor layer 15 and the metal layer 63. The p-side electrode 61 is in contact with the second layer 12. A part of the p-side electrode 61 extends to the outside of the side surface of the semiconductor layer 15 and a p-side pad 62 is provided on the extension portion. The second layer 12 is electrically connected to the p-side pad 62 via the p-side electrode 61.

An insulating film 65 is provided between the p-side electrode 61 and the metal layer 63, and thus the p-side electrode 61 and the metal layer 63 are insulated.

On the metal layer 63, a plurality of n-side electrodes 63a is provided integrally with the metal layer 63. The n-side electrode 63a reaches the first layer 11 through the p-side electrode 61, the second layer 12, and the light emitting layer 13, and is electrically connected to the first layer 11. The insulating film 65 is provided between the n-side electrode 63a and the light emitting layer 13, between the n-side electrode 63a and the second layer 12, and between the n-side electrode 63a and the p-side electrode 61.

The semiconductor layer 15 is grown on an above-described single-crystal substrate. After the p-side electrode 61, the n-side electrode 63a and the like are formed, the semiconductor layer 15 is bonded to the support substrate 10 via the metal layer 63. The support substrate 10 has a conductive property, and is, for example, a silicon substrate.

Accordingly, the first layer 11 is electrically connected to the metal layer (back electrode) 64 via the n-side electrode 63a, the metal layer 63, and the support substrate 10.

After the semiconductor layer 15 is bonded to the support substrate 10, the single-crystal substrate is removed to expose a surface of the first layer 11. After the asperity surface 15a is formed on the surface of the first layer 11, the transparent inorganic material layer 19 is formed and the fluorescent material layer 30 is bonded to the semiconductor layer 15 via the transparent inorganic material layer 19.

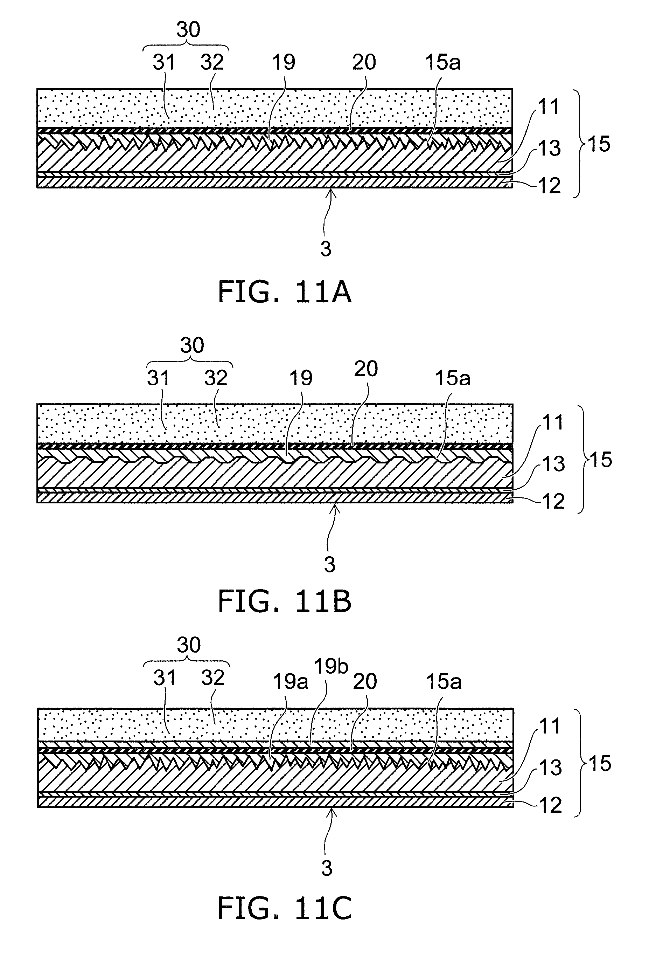

FIGS. 11A and 11B are schematic enlarged sectional views of a part of a semiconductor light emitting device of a still another embodiment. FIG. 11A corresponds to the cross-section of the above FIG. 1A, and FIG. 11B corresponds to the cross-section of the above FIG. 2A.

According to the embodiment shown in FIGS. 11A and 11B, a fluorescent reflection film 20 of an inorganic material is provided between the inorganic material layer 19 and the fluorescent material layer 30.

Alternatively, as shown in FIG. 11C, the fluorescent reflection film 20 is provided between the first inorganic material layer 19a and the second inorganic material layer 19b. For example, the first inorganic material layer 19a and the second inorganic material layer 19b are made of the same material. That is, the fluorescent reflection film 20 is provided in the inorganic material layer. The first inorganic material layer 19a and the second inorganic material layer 19b may be made of different materials.

The fluorescent reflection film 20 has a reflectance with respect to a fluorescent wavelength of the fluorescent material 31 higher than a reflectance with respect to an emission wavelength of the light emitting element 3. The fluorescent reflection film 20 reflects a component of fluorescent material output light traveling toward the light emitting element 3 side. The excitation light of the light emitting element 3 is relatively low reflective to the fluorescent reflection film 20, and the output light of the fluorescent material 31 is relatively highly reflective to the fluorescent reflection film 20.

The fluorescent reflection film 20 reduces ratios of absorption loss and scattering loss of the fluorescent material output light returned to the light emitting element 3 side without reducing largely uptake efficiency of the excitation light of the light emitting element 3. This increases luminous efficiency when viewing from outside.

Here, a refractive index of the inorganic material layer 19 is taken as n1, a thickness of the inorganic material layer 19 is taken as h1, a refractive index of the fluorescent reflection film 20 is taken as n2, a thickness of the fluorescent reflection film 20 is taken as h2, an equivalent refractive index of the fluorescent material layer 30 is taken as n3, and a thickness of the fluorescent material layer 30 is taken as h3.

In the case where the fluorescent reflection film 20 is provided between the first inorganic material layer 19a and the second inorganic material layer 19b, a refractive index and a thickness of the second inorganic material layer 19b between the fluorescent reflection film 20 and the fluorescent material layer 30 are taken as n3 and h3, respectively.

The thickness h1 of the inorganic material layer 19 and the thickness h3 of the fluorescent material layer 30 (or the second inorganic material layer 19b) are set to be sufficiently larger than an excitation light wavelength (the emission wavelength of the light emitting element 3) λ0.

For example, in the case of n2<(n1n3)^{1/2}, n2h2=λ0 (1+2m)/4 (m=0, 1, 2, 3 ...) is set.

In the case of n2>(n1n3)^{1/2}, n2h2=λ0 (1+m)/2 (m=0, 1, 2, 3 ...) is set.

For example, in the case of n2<(n1n3)^{1/2}, the thickness h2 of the fluorescent reflection film 20 is set to be n2h2=λ0/4, λ0 (3/4), λ0 (5/4) ....

In the case of n2>(n1n3)^{1/2}, the thickness h2 of the fluorescent reflection film 20 is set to be n2h2=λ0/2, λ0 (3/2) ....

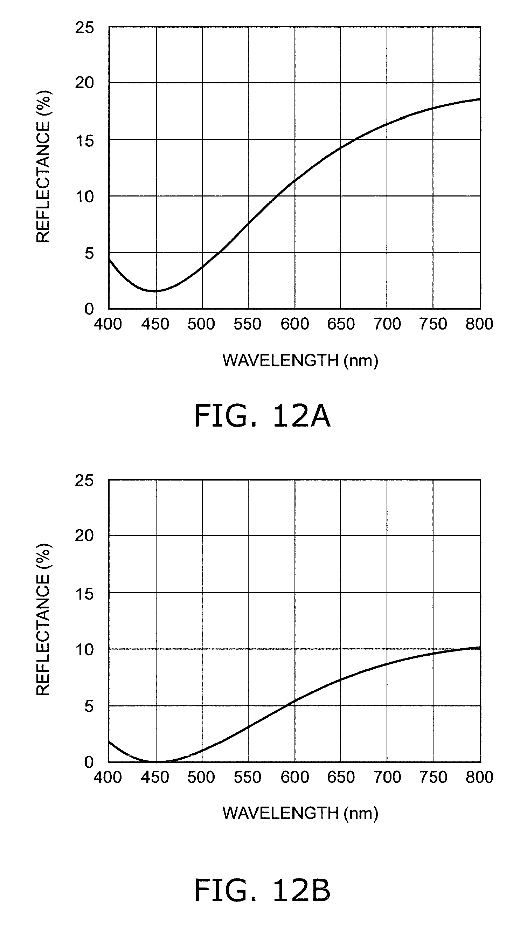

FIGS. 12A and 12B show a wavelength dependence example of the reflectance of the fluorescent reflection film 20.

FIG. 12A shows characteristic of the following configuration.

The fluorescent material layer 30 includes the glass member 32 made of mixture of Al₂O₃ and Si₃N₄ and the fluorescent material 31 dispersed in the glass member 32. The equivalent refractive index n3 of the fluorescent material layer 30 is about 1.9. The fluorescent reflection film 20 is a titanium oxide (TiO₂) film having the refractive index n2 of about 2.7 and the thickness h2 of 85 nm. The inorganic material layer 19 is a SiO₂ layer having the refractive index n1 of about 1.5.

FIG. 12B shows characteristic of the following configuration.

The fluorescent material layer 30 includes the glass member 32 made of SiO₂ and the fluorescent material 31 dispersed in the glass member 32. The equivalent refractive index n3 of the fluorescent material layer 30 is about 1.5. The fluorescent reflection film 20 is a silicon nitride (Si₃N₄) film having the refractive index n2 of about 2.0 and the thickness h2 of 110 nm. The inorganic material layer 19 is a SiO₂ layer having the refractive index n1 of about 1.5.

In the case where the equivalent refractive index n3 of the fluorescent material layer 30 is about 1.9, as shown in FIG. 12A, the reflectance of the excitation light (wavelength λ0=450 nm) of the light emitting element 3 is 1.6%, and the reflectance of a yellow fluorescent material output (wavelength 560 nm) is 8.4%. The reflectance of the yellow fluorescent material output is about 5 times higher than the reflectance of the excitation light of the light emitting element 3.

In the case where the equivalent refractive index n3 of the fluorescent material layer 30 is about 1.5, as shown in FIG. 12B, the reflectance of the excitation light (wavelength λ0=450 nm) of the light emitting element 3 is 0.006%, and the reflectance of the yellow fluorescent material output (wavelength 560 nm) is 3.6%. The reflectance of the yellow fluorescent material output is about 600 times higher than the reflectance of the excitation light of the light emitting element 3.

The emission spectrum of the yellow fluorescent material output spreads close to a red region, however luminance in the red region is low and thus color rendering property has tendency to be low.

According to the fluorescent reflection film 20 of the embodiment, as seen from FIGS. 12A and 12B, the reflectance of the wavelength far from the excitation light wavelength is high.

As shown in FIG. 12A, in the case where the equivalent refractive index n3 of the fluorescent material layer 30 is about 1.9, the reflectance of light at wavelength 700 nm is 16.4%. This is a reflectance higher than about 2 times with respect to the yellow fluorescent wavelength (560 nm) and about 10 times with respect to the excitation light wavelength.

As shown in FIG. 12B, in the case where the equivalent refractive index n3 of the fluorescent material layer 30 is about 1.5, the reflectance of light at wavelength 700 nm is 8.6%. This is a reflectance higher than about 2.4 times with respect to the yellow fluorescent wavelength (560 nm) and about 1400 times with respect to the excitation light wavelength.

Loss component due to the light emitting element 3 of the fluorescent output of the fluorescent material 31 is suppressed by the fluorescent reflection film 20 having the characteristic of FIG. 12A or 12B. Furthermore, improvement effect of the color rendering property is produced with the effect that the long wavelength light having low luminance becomes highly reflective.

Here, the fluorescent reflection film 20 may be provided to have the structure shown in FIG. 1B, FIG. 1C, FIG. 2B, FIG. 2C, FIG. 5, FIG. 7, and FIG. 10.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A semiconductor light emitting device comprising:
a light emitting element (3) having an asperity surface (15a);
a fluorescent material layer (30) provided on the asperity surface (15a), the fluorescent material layer (30) having a glass member (32) and a fluorescent material (31) dispersed in the glass member (32); and
an inorganic material layer (19) provided between the asperity surface (15a) and the fluorescent material layer (30), the inorganic material layer (19) being in contact with the asperity surface (15a) and the fluorescent material layer (30), and transmissive to light emitted from the light emitting element (3).

2. The device according to claim 1, wherein surface roughness of a surface of the inorganic material layer (19) on the fluorescent material layer (30) side is smaller than surface roughness of a surface of the inorganic material layer (19) on the light emitting element (3) side.

3. The device according to claim 1, wherein asperities are provided on a surface of the inorganic material layer (19) on the fluorescent material layer (30) side.

4. The device according to any of claims 1-3, wherein
the inorganic material layer (19) includes
a first inorganic material layer (19a) provided on the light emitting element (3) side and
a second inorganic material layer (19b) provided on the fluorescent material layer (30) side.

5. The device according to any of claims 1-4, wherein a refractive index of the glass member (32) is lower than a refractive index of the light emitting element (3) and is higher than a refractive index of the inorganic material layer (19).

6. The device according to any of claims 1-3 and 5, further comprising:
a fluorescent reflection film (20) provided between the inorganic material layer (19) and the fluorescent material layer (30), the fluorescent reflection film (20) having a reflectance with respect to a fluorescence wavelength of the fluorescent material (31) higher than a reflectance with respect to an emission wavelength of the light emitting element (3).

7. The device according to claim 4, further comprising:
a fluorescent reflection film (20) provided between the first inorganic material layer (19a) and the second inorganic material layer (19b), the fluorescent reflection film (20) having a reflectance with respect to a fluorescence wavelength of the fluorescent material (31) higher than a reflectance with respect to an emission wavelength of the light emitting element (3).

8. The device according to any of claims 1-7, further comprising:
an insulating layer (18, 25) provided on a side surface (15c) of the light emitting element, wherein
a side surface of the fluorescent material layer (30) and a side surface of the insulating layer (18, 25) are aligned.

9. The device according to claim 8, wherein the fluorescent material layer (30) is also provided on the insulating layer (18, 25) at a region outside of the side surface (15c) of the light emitting element.

10. The device according to any of claims 1-9, wherein the inorganic material layer (19) has a conductive property.

11. The device according to any of claims 1-10, wherein the fluorescent material layer (30) does not include a resin.

12. The device according to any of claims 1-11, wherein a substrate is not included between the light emitting element (3) and the fluorescent material layer (30).

13. The device according to any of claims 1-12, wherein the glass member (32) includes at least any of a borosilicate glass, a soda lime glass, an alumina silicate glass, a quartz, and quart.

14. A method for manufacturing a semiconductor light emitting device comprising:
forming an inorganic material layer (19) transmissive to light emitted from a light emitting element (3) on an asperity surface (15a) of the light emitting element (3);
smoothening a surface of the inorganic material layer (19); and
bonding a fluorescent material layer (30) having at least a glass member (32) and a fluorescent material (31) dispersed in the glass member (32) to the smoothened surface of the inorganic material layer (19).

15. The method according to claim 14, wherein an average roughness of the surface of the inorganic material layer (19), and an average roughness of a surface of the fluorescent material layer (30) to be bonded to the inorganic material layer (19) are 0.5 nm or less.

16. A method for manufacturing a semiconductor light emitting device comprising:
forming a first inorganic material layer (19a) transmissive to light emitted from a light emitting element (3) on an asperity surface (15a) of the light emitting element (3);
smoothening a surface of the first inorganic material layer (19a);
forming a second inorganic material layer (19b) transmissive to light emitted from the light emitting element (3) on a surface of a fluorescent material layer (30) having a glass member (32) and a fluorescent material (31) dispersed in the glass member (32);
smoothening a surface of the second inorganic material layer (19b); and
bonding the smoothened surface of the first inorganic material layer (19a) and the smoothened surface of the second inorganic material layer (19b) together.

17. The method according to claim 16, wherein an average roughness of the surface of the first inorganic material layer (19a), and an average roughness of the surface of the second inorganic material layer (19b) are 0.5 nm or less.

18. The method according to claim 16 or 17, further comprising:
forming asperities on the surface of the fluorescent material layer (30), wherein
the second inorganic material layer (19b) is formed on the surface of the fluorescent material layer (30), and covers the asperities.

19. The method according to claim 18, wherein the fluorescent material (31) is exposed to the surface of the fluorescent material layer (30) to form the asperities by etching of the glass member (32).

20. The method according to claim 18, wherein asperities are formed on a back surface of the second inorganic material layer (19b), and the fluorescent material layer (30) is melted and coated on the asperities of the back surface of the second inorganic material layer (19b).
